# EUROPÄISCHE PATENTSCHRIFT

(11) **EP 0 660 654 B1**
(45) Veröffentlichungstag und Bekanntmachung des Hinweises auf die Patenterteilung: **04.09.1996**
(21) Anmeldenummer: 94118833.6
(22) Anmeldetag: 30.11.1994
(51) Int. Cl.: H05K 7/20, B01D 46/10

(54) **Filterlüfter zum Anbau insbesondere an Seitenwänden von Schaltschränken und dergleichen**
Fan with filter especially for mounting on switch cabinet side panels or similar
Ventilateur à filtre pour montage en particulier sur des parois latérales d'armoires de commutation et analogue

(30) Priorität: 24.12.1993 DE 4344659
(43) Veröffentlichungstag der Anmeldung: 28.06.1995
(73) Patentinhaber: häwa Programmgehäuse und Komponenten GmbH & Co. KG, D-88489 Wain (DE)
(72) Erfinder: Schauwecker, Erwin, D-88477 Hörenhausen (DE); Kohler, Erwin, D-88489 Wain (DE)
(74) Vertreter: Dziewior, Joachim, Dipl.-Phys. Dr.

(56) Entgegenhaltungen:
- EP-A- 0 439 667
- DE-U- 9 306 032
- US-A- 4 385 911
- PATENT ABSTRACTS OF JAPAN vol. 18, no. 32 (C-1154) 18. Januar 1994 & JP-A-05 261 227 (TOKYO ELECTRIC CO LTD) 12. Oktober 1993
- 261 227 (TOKYO ELECTRIC CO LTD) 12. Oktober 1993
- PATENT ABSTRACTS OF JAPAN vol. 18, no. 32 (C-1154) 18. Januar 1994 & JP-A-05 261 227

## Beschreibung

Die Erfindung betrifft einen Filterlüfter zum Anbau insbesondere an Seitenwänden von Schaltschränken und dergleichen, bestehend aus einer geschlossenen, lediglich nach unten und zur Seite des Schaltschranks hin offenen Lüfterhaube mit im wesentlichen rechteckigen Wandteilen, sowie mit einer in die Lüfterhaube eingesetzten, im wesentlichen ebenen Filtermatte.

Aus EP-A-0 439 667 ist ein Filterlüfter bekannt, der für den Einbau in der Wand eines Schaltschraukes geeignet ist, wobei die Montagewand für den Filterlüfter mit einer Durchbrechung versehen ist, in der der Filterlüfter gehalten und befestigt ist.

Derartige Filterlüfter sind aus der Praxis bekannt und ermöglichen die Belüftung von Schaltschränken und ähnlichen abgeschlossenen Räumen, aus denen Wärme abgeführt werden muß, ohne daß Staub und ähnliche Verschmutzungen in deren Inneres eindringen können.

Abhängig von den Umgebungsbedingungen ist es häufig erforderlich, derartige Filterlüfter in wassergeschützter Ausführungsform vorzusehen, die einen hohen Wasserschutz beim Einsatz an solchen Schaltschränken bieten, die öfters außen gereinigt werden müssen, bzw. die in einer Umgebung stehen, in der mit Strahlwasser zu rechnen ist.

Maßnahmen, die den geforderten Wasserschutz gewährleisten, haben jedoch häufig den Nachteil, sich reduzierend auf den Luftdurchsatz auszuwirken, so daß die Wärmeabfuhr aus dem Schaltschrank bzw. dem Gehäuse beeinträchtigt wird.

Der Erfindung liegt die Aufgabe zugrunde, einen Filterlüfter der eingangs genannten Art zu schaffen, der bei größtmöglichem Luftdurchsatz einen wirkungsvollen Wasserschutz gewährleistet.

Diese Aufgabe wird nach der Erfindung dadurch gelöst, daß die Filtermatte in der Weise schräg im Inneren der Lüfterhaube angeordnet ist, daß sie mit ihrem unteren Rand dem am Schaltschrank angeschlossenen Wandteil und mit ihrem oberen Rand dem dem Schaltschrank abgewandten Wandteil anliegt.

Der durch die Erfindung erreichte Vorteil besteht im wesentlichen darin, daß durch die schräge Anordnung der Filtermatte deren beide Oberflächen frei zugänglich sind, d. h. mit maximaler Oberfläche für den Luftdurchsatz zur Verfügung stehen. Im Gegensatz zu den üblichen Anordnungen der Filtermatte, bei der diese dem Wanddurchbruch der Seitenwand des Schaltschrankes anliegt, ist somit ein wesentlich größerer Luftdurchsatz gewährleistet, da die Wanddurchbrüche in der Seitenwand des Schaltschranks stets kleiner als die Fläche der Filtermatte sind. Dies gilt insbesondere für diejenigen Filterlüfter, an denen der Lüftermotor angeordnet ist, da hier nur ein der Form des Lüftermotors angepaßter, kreisrunder Wanddurchbruch vorhanden sein kann.

Durch die schräg angeordnete Filtermatte wird weiter sichergestellt, daß eventuell doch von unten in die Lüfterhaube eindringendes Spritzwasser stets zur Außenseite der Filtermatte hin abläuft und von dort aus durch die untere Öffnung der Lüfterhaube abtropft.

Die Lüfterhaube ist im übrigen mit ihren Rändern wasserdicht am Schaltschrank angeschlossen.

In bevorzugter Ausführungsform der Erfindung ist die Filtermatte in einen Halterahmen eingeschoben, der von einer mit Aussparungen versehenen Stützplatte und zwei randseitig daran angeschlossenen, sich gegenüberstehenden und die Filtermatte umgreifenden Winkelleisten gebildet ist. Die Aussparungen sind vorteilhafterweise rechteckförmig ausgebildet und bilden zwischen sich schmale Stege, wodurch ein maximaler Luftdurchsatz durch die Filtermatte gewährleistet ist.

Der Halterahmen ist an seinem unteren Ende zweckmäßigerweise mit Anschlußlaschen für Haltewinkel versehen, der die untere Stirnseite der Filtermatte und den darin anschließenden Randstreifen umgreift. Hierdurch wird die Filtermatte mit ihrem unteren Rand dicht gegen die Seitenwand des Schaltschrankes angepreßt, wodurch verhindert wird, daß zwischen der Filtermatte und der Seitenwand des Schaltschrankes Wasser eindringen kann. Da der Haltewinkel die Stirnseite der Filtermatte überdeckt, kann auch stirnseitig in die Filtermatte kein Wasser eindringen.

Die Stützplatte ist zweckmäßigerweise auf der dem Schaltschrank zugewandten Seite der Filtermatte angeordnet.

Schließlich ist vorgesehen, daß das obere Wandteil der Lüfterhaube von der Seitenwand des Schaltschranks aus schräg abwärts geneigt verläuft. Hierdurch kann kein Wasser auf der Oberseite der Lüfterhaube stehen bleiben.

Im folgenden wird die Erfindung an einem in der Zeichnung dargestellten Ausführungsbeispiel näher erläutert; es zeigen:
- Fig. 1: einen Filterlüfter im Querschnitt mit angeflanschtem Lüftermotor,

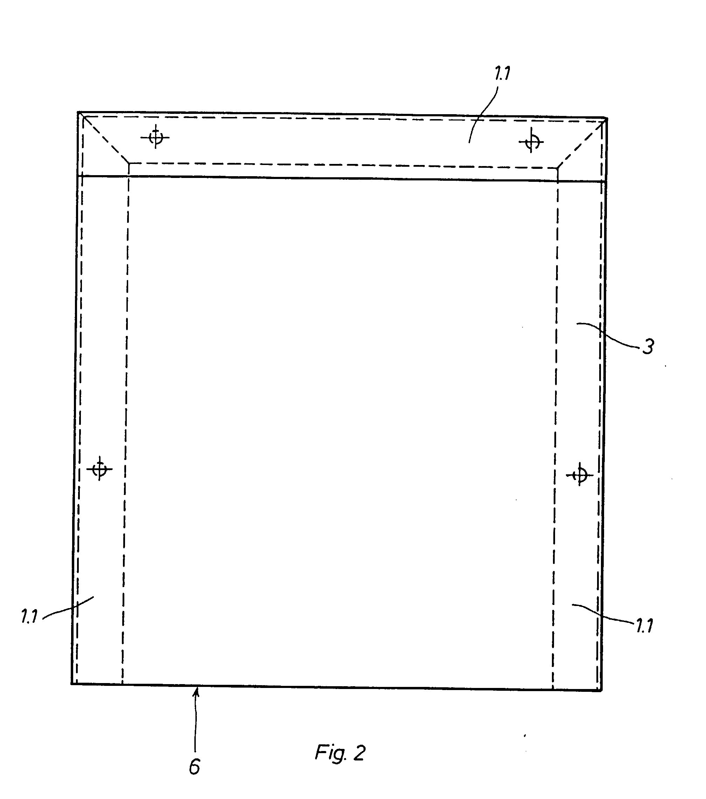

- Fig. 2: den Gegenstand nach Fig. 1 in Richtung II in Draufsicht,
- Fig. 3: den Gegenstand nach Fig. 1, jedoch ohne Lüftermotor und Filtermatte,
- Fig. 4: den Halterahmen für die Filtermatte in Draufsicht,
- Fig. 5: den Gegenstand nach Fig. 4 im Querschnitt,

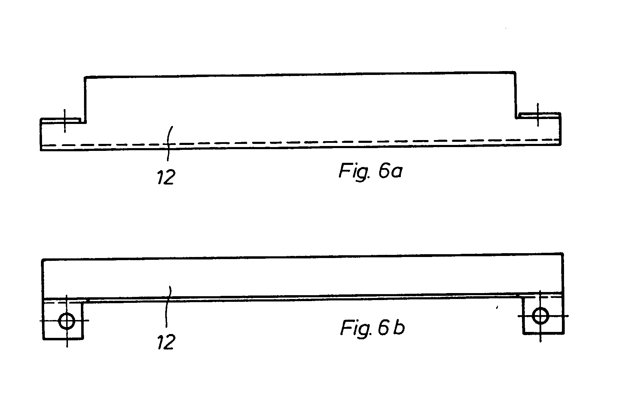

- Fig. 6: den Haltewinkel in Vorderansicht und Draufsicht.

Der in der Zeichnung dargestellte Filterlüfter 1 ist zum Anbau insbesondere an Seitenwänden 2 von Schaltschränken, Gehäusen und dergleichen vorgesehen. Er besteht aus einer geschlossenen, lediglich nach unten und zur Seite des Schaltschranks hin offenen Lüfterhaube 3, die aus im wesentlichen rechteckigen Wandteilen zusammengesetzt ist. In die Lüfterhaube 3 ist eine im wesentlichen ebene Filtermatte 4 eingesetzt, die das Eindringen von Staub oder sonstigen Partikeln in den Schaltschrank verhindert. Derartige Filterlüfter 1 sind sowohl an der Lufteinlaßöffnung wie auch an der Luftauslausöffnung vorgesehen, so daß auch bei abgestelltem Lüftergebläse sichergestellt ist, daß an der Auslaßseite kein Schmutz eindringen kann.

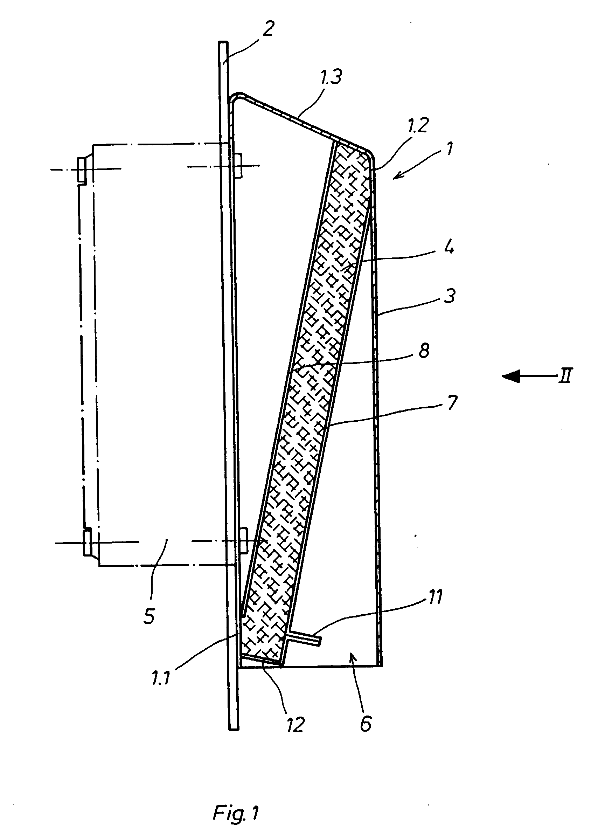

Vorzugsweise an der Luftauslaßseite ist auf der Innenseite des Schaltschranks an der Seitenwand ein Lüftermotor 5 vorgesehen, wie dies in Fig. 1 angedeutet ist. Der Lüftermotor 5 bläst die aus dem Inneren des Schaltschrankes stammende, angewärmte Luft in die Lüfterhaube 1, von dort durch die Filtermatte 4 und anschließend senkrecht nach unten ins Freie.

Um den Filterlüfter 1 auch an Schaltschränken einsetzen zu können, bei denen ein hoher Wasserschutz gefordert wird, wenn sie beispielsweise öfters von außen gereinigt werden müssen bzw. in einer Umgebung stehen, in denen mit Strahlwasser zu rechnen ist, ist vorgesehen, daß die Filtermatte 4 schräg im Inneren der Lüfterhaube 1 angeordnet ist. Die Anordnung der Filtermatte 4 erfolgt dabei in der Weise, daß sie mit ihrem unteren Rand dem am Schaltschrank angeschlossenen Wandteil 1.1 und mit ihrem oberen Rand dem dem Schaltschrank abgewandten Wandteil 1.2 anliegt. Auf diese Weise stehen beide Seiten der Filtermatte 4 im wesentlichen uneingeschränkt für den Luftdurchtritt zur Verfügung, so daß auch beim Einsatz solcher Filtermatten 4, die einen erhöhten Wasserschutz bieten und dadurch ggf. einen größeren Strömungswiderstand besitzen, ein größtmöglicher Luftdurchsatz gewährleistet ist. Durch die schräge Anordnung der Filtermatte 4 ist weiter sichergestellt, daß gleichwohl in die Filtermatte 4 eingedrungenes Wasser stets zur Außenseite hin abläuft und dort von der Oberfläche durch die untere Öffnung 6 der Lüfterhaube 1 abtropft.

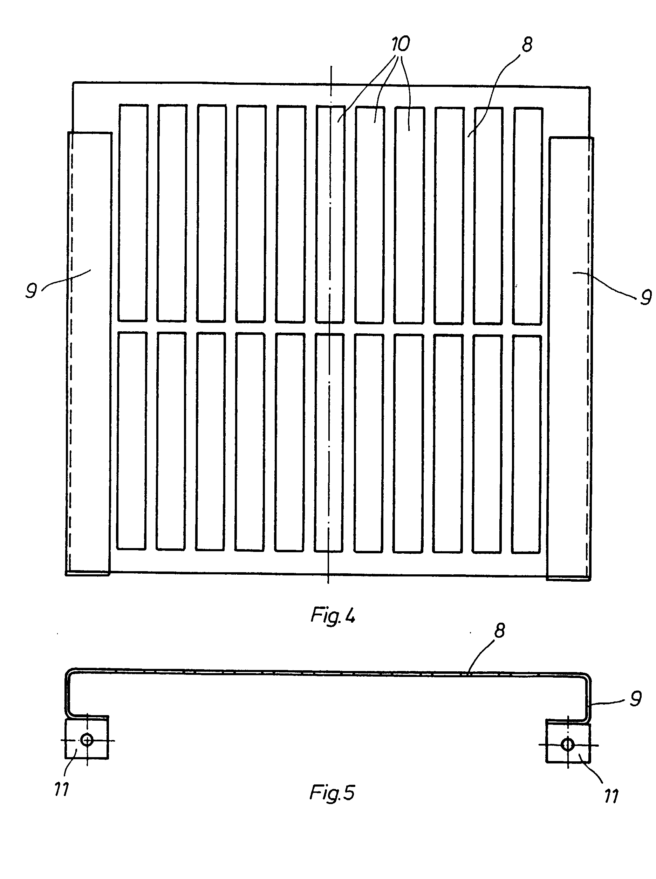

Die Filtermatte 4 selbst ist in einen Halterahmen 7 eingeschoben, der von einer mit Aussparungen 10 versehenen Stützplatte 8 und zwei randseitig daran angeschlossenen Winkelleisten 9 gebildet ist, die sich gegenüberstehen und die Filtermatte 4 umgreifen. Die Aussparungen 10 selbst sind, wie sich aus der Fig. 4 ergibt, rechteckförmig ausgebildet und bilden zwischen sich schmale Stege. Auf diese Weise wird der Luftdurchsatz nicht oder allenfalls geringfügig beeinflußt.

Der Halterahmen 7 ist an seinem unteren Ende mit Anschlußlaschen 11 für einen Haltewinkel 12 versehen, der die untere Stirnseite der Filtermatte 4 und den daran anschließenden Randstreifen umgreift. Auf diese Weise wird eine optimale Abdichtung des unteren Randes der Filtermatte 4 gegen die Seitenwand 2 des Schaltschrankes erreicht. Darüberhinaus ist die Stirnseite der Filtermatte 4 abgedeckt, so daß von daher kein Strahlwasser eindringen kann.

Die Stützplatte 8 ist auf der dem Schaltschrank zugewandten Seite der Filtermatte 4 angeordnet.

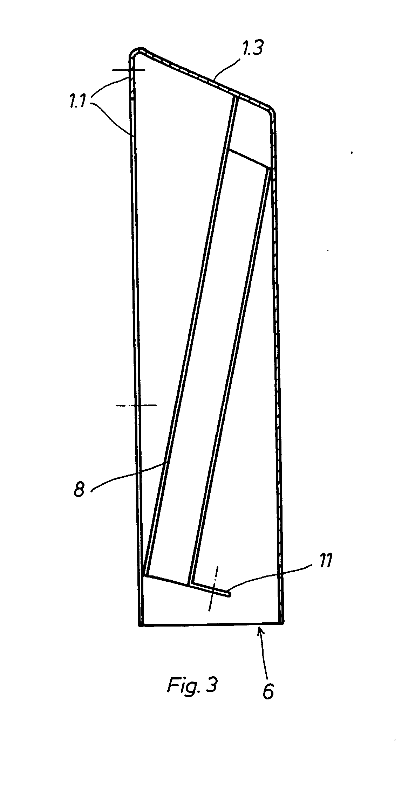

Das obere Wandteil 1.3 der Lüfterhaube 1 verläuft von der Seitenwand 2 des Schaltschranks aus schräg abwärts geneigt, wie sich aus den Figuren 1 und 3 erkennen läßt. Dadurch kann auf der Oberseite der Lüfterhaube 1 kein Wasser stehen bleiben, sondern fließt zur dem Schaltschrank abgewandten Seite hin ab.

## Patentansprüche

1. Filterlüfter zum Anbau insbesondere an Seitenwänden von Schaltschränken, bestehend aus einer geschlossenen, lediglich nach unten und zur Seite des Schaltschranks hin offenen Lüfterhaube (3) mit im wesentlichen rechteckigen Wandteilen, sowie mit einer in die Lüfterhaube (3) eingesetzten, im wesentlichen ebenen Filtermatte (4), dadurch gekennzeichnet, daß die Filtermatte (4) in der Weise schräg im Inneren der Lüfterhaube (3) angeordnet ist, daß sie mit ihrem unteren Rand dem am Schaltschrank angeschlossenen Wandteil (1.1) und mit ihrem oberen Rand dem dem Schaltschrank abgewandten Wandteil (1.2) anliegt.

2. Filterlüfter nach Anspruch 1, dadurch gekennzeichnet, daß die Filtermatte (4) in einen Halterahmen (7) eingeschoben ist, der von einer mit Aussparungen (10) versehenen Stützplatte (8) und zwei randseitig daran angeschlossenen, sich gegenüberstehenden und die Filtermatte (4) umgreifenden Winkelleisten (9) gebildet ist.

3. Filterlüfter nach Anspruch 2, dadurch gekennzeichnet, daß die Aussparungen (10) rechteckförmig ausgebildet sind und zwischen sich schmale Stege bilden.

4. Filterlüfter nach Anspruch 2 oder 3, dadurch gekennzeichnet, daß der Halterahmen (7) an seinem unteren Ende mit Anschlußlaschen (11) für einen Haltewinkel (12) versehen ist, der die untere Stirnseite der Filtermatte (4) und den daran anschließenden Randsteifen umgreift.

5. Filterlüfter nach einem der Ansprüche 2 bis 4, dadurch gekennzeichnet, daß die Stützplatte (8) auf der dem Schaltschrank zugewandten Seite der Filtermatte (6) angeordnet ist.

6. Filterlüfter nach einem der Ansprüche 1 bis 5, dadurch gekennzeichnet, daß das obere Wandteil (1.3) der Lüfterhaube (3) von der Seitenwand (2) des Schaltschranks aus schräg abwärts geneigt verläuft.

## Claims

1. A filter ventilator for mounting in particular to side walls of switch cabinets, comprising a closed ventilator hood (3) which is open only downwardly and towards the side of the switch cabinet, with substantially rectangular wall portions, and with a substantially flat filter mat (4) which is fitted into the ventilator hood (3), characterised in that the filter mat (4) is arranged inclinedly in the interior of the ventilator hood (3) in such a way that it bears with its lower edge against the wall portion (1.1) connected to the switch cabinet and with its edge against the wall portion (1.2) which is remote from the switch cabinet.

2. A filter ventilator according to claim 1 characterised in that the filter mat (4) is inserted into a holding frame (7) which is formed by a support plate (8) provided with openings (10), and two angle strips (9) which are connected thereto at the edges and which are disposed in opposite relationship to each other and Which embrace the filter mat (4).

3. A filter ventilator according to claim 2 characterised in that the openings (10) are of a rectangular configuration and form narrow web portions between them.

4. A filter ventilator according to claim 2 or claim 3 characterised in that at its lower end the holding frame (7) is provided with connecting lugs (11) for a holding angle portion (12) which embraces the lower end of the filter mat (4) and the edge strip adjoining same.

5. A filter ventilator according to one of claims 2 to 4 characterised in that the support plate (8) is arranged on the side of the filter mat (6), which is towards the switch cabinet.

6. A filter ventilator according to one of claims 1 to 5 characterised in that the upper wall portion (1.3) of the ventilator hood (3) extends obliquely inclinedly downwardly from the side wall (2) of the switch cabinet.

## Revendications

1. Ventilateur à filtre destiné à être monté notamment sur des parois latérales d'armoires électriques, constitué par une coque fermée de ventilateur (3), ouverte simplement vers le bas et vers le côté de l'armoire électrique, et comportant des éléments de paroi sensiblement rectangulaires, ainsi qu'un mat filtrant essentiellement plat (4), inséré dans la coque (3) du ventilateur, caractérisé en ce que le mat filtrant (4) est disposé obliquement à l'intérieur de la coque (3) du ventilateur de telle sorte qu'il s'applique, par son bord inférieur, contre l'élément de paroi (1.1) raccordé à l'armoire électrique, et par son bord supérieur, à l'élément de paroi (1.2) situé à l'opposé de l'armoire électrique.

2. Ventilateur à filtre selon la revendication 1, caractérisé en ce que le mat filtrant (4) est inséré dans un cadre de fixation (7), qui est formé par une plaque de support (8) pourvue d'ouvertures (10) et par deux barrettes en forme de cornières (9) qui se raccordent marginalement à cette plaque, qui sont situées à l'opposé l'une de l'autre et enserrent le mat filtrant (4).

3. Ventilateur à filtre selon la revendication 2, caractérisé en ce que les ouvertures (10) sont agencées avec une forme rectangulaire et forment entre elles d'étroites barrettes.

4. Ventilateur à filtre selon la revendication 2 ou 3, caractérisé en ce que le cadre de fixation (7) comporte, sur son extrémité inférieure, des pattes de raccordement (11) pour une cornière de fixation (12), qui entoure la face avant inférieure du mat filtrant (4) et les bandes marginales s'y raccordant.

5. Ventilateur à filtre selon l'une des revendications 2 à 4, caractérisé en ce que la plaque de support (8) est disposée sur le côté du mat filtrant (6), tourné vers l'armoire électrique.

6. Ventilateur à filtre selon l'une des revendications 1 à 5, caractérisé en ce que l'élément de paroi supérieur (1.3) de la coque (3) du ventilateur est incliné vers le bas à partir de la paroi latérale (2) de l'armoire électrique.
